(19) Europäisches Patentamt / European Patent Office / Office européen des brevets

(11) **EP 2 551 110 B1**

(12) **EUROPEAN PATENT SPECIFICATION**

(45) Date of publication and mention
of the grant of the patent:
**23.04.2014 Bulletin 2014/17**

(51) Int Cl.:
*B32B 27/40* *(2006.01)*    *B32B 27/06* *(2006.01)*
*G09F 9/33* *(2006.01)*    *H01L 31/042* *(2014.01)*
*H01L 31/048* *(2014.01)*    *G09F 9/30* *(2006.01)*

(21) Application number: **12176550.7**

(22) Date of filing: **16.07.2012**

(54) **Impact resistant device comprising an optical layer**

Stoßfeste Vorrichtung mit optischer Schicht

Dispositif résistant aux chocs comprenant une couche optique

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **29.07.2011 US 201161512955 P**

(43) Date of publication of application:
**30.01.2013 Bulletin 2013/05**

(73) Proprietor: **Creator Technology B.V.
4837 BN Breda (NL)**

(72) Inventors:
• **Bouten, Lucas Martinus
5616 LZ Eindhoven (NL)**
• **Schellekens, Michiel Adrianus Johannes H. J.
5616 LZ Eindhoven (NL)**
• **van Veenendaal, Erik
5616 LZ Eindhoven (NL)**
• **Huitema, Hjalmar Edzer Ayco
5616 LZ Eindhoven (NL)**

(74) Representative: **Goddar, Heinz J.
Boehmert & Boehmert
Pettenkoferstrasse 20-22
80336 München (DE)**

(56) References cited:
EP-A2- 1 191 605      WO-A1-2008/133513
US-A1- 2003 026 971      US-A1- 2007 084 501

**Description**

FIELD AND BACKGROUND OF THE INVENTION

The present invention relates to an impact resistant device comprising an optical layer such as an impact resistant display device.

The term "impact resistance" is used hereinafter to refer to the desired ability of a device or layer to resist a certain impact, e.g. as a result of a projectile or fall of the device, while still maintaining normal functionality after the impact. The term "impact" is defined hereinafter as a collision of an object with the device at a relative velocity of more than 0.1 m/s. The term "optical layer" is used hereinafter to refer to a layer or combination of layers that provides a functional effect when electromagnetic radiation, in particular light of optical frequencies, is absorbed, emitted, or transmitted by the optical layer. Active functional effects include e.g. electro-optical energy conversion (transducing) wherein light is emitted or absorbed by the optical layer itself. Passive functional effects include selective reflection, transmission or other alteration of light from a secondary light source. An optical layer is generally present in display devices wherein, as an example, a functional effect may be that the optical layer is used to present visual information to a user. Such a display device comprises components such as electronics to control and/or interface with the optical layer to provide the functional effect.

For example, in cathode ray tube display devices (CRTs), an optical layer is formed by a fluorescent layer that is activated by an electron beam which is controlled by electronics in the device. CRTs are typically provided with reasonable impact resistance, e.g. by the thick glass layer that forms the front of the display. In recent years, through the common desire for thinner and/or lower weight display devices, CRTs have been mostly replaced by liquid crystal display devices (LCDs). For example, in LCDs, an optical layer may be formed by the combination of a liquid crystal front layer that modulates a transmission of light emitted by a back-light source. In another class of possibly even thinner display and more light-weight devices, commonly known as e-reader display devices (e-readers) an optical layer may be formed e.g. by micro-capsules containing an electrophoretic ink that changes its reflective properties as a result of electric driving fields controlled by the electronics therein. In either of these thin display devices, electronics that control the operation of the optical layer may be provided in a thin electronics layer that is provided in or near the optical layer.

During its lifetime a display is bound to encounter several impacts by objects of varying sizes and shapes and with varying impact force. Especially those displays that are used in applications designed for more casual use, such as e.g. e-readers for school children. A problem of current thin display devices is to provide a sufficient impact resistance. Also, there is a large demand for larger displays for mobile, e-reader and educational markets. The two factors that are most important for these larger displays are low weight and higher impact resistance, as the return rates of devices with broken displays increases dramatically with larger display size. The combination of low weight and high impact resistance cannot be delivered by the current solutions.

A typical solution for increasing the impact resistance of a display device is to provide an impact resistant transparent front-layer such as a reinforced glass or an acrylic resin plate to shield the sensitive optical layer from possible impact. Unfortunately, such an impact resistant layer may obscure the view of the optical layer and increase the thickness and/or weight of the thin display device which goes against the aforementioned common desire for a thinner display device. As a partial solution to this e.g. US 2005/0077826 discloses an impact-resistant film for a flat display panel, which is to be attached to the front glass of a flat display panel to prevent breakage of the front glass by an impact and at the same time provide some reduction of weight and thickness compared to conventional protective covers.

Disadvantageously, known measures of providing protection to a display device may obscure the view of the optical layer and thereby cause a deterioration of the visual quality of the display. Also the known measures may provide an undesirable increased thickness and/or weight of the display device. There is yet a need for a display device with an improved impact resistance that does not suffer from the aforementioned disadvantages. The solution to the above technical problem is achieved by providing the subject matter defined in the claims.

SUMMARY OF THE INVENTION

In a first aspect there is provided an impact resistant foil device comprising an optical layer, electronics, and a backing structure. The optical layer is visible from a front side of the device. The electronics are arranged for controlling and/or interfacing with the optical layer. The optical layer and electronics are comprised in a flexible foil structure that has a pressure threshold and a stretching threshold below which the optical layer and electronics are not damaged. The backing structure is in mechanical contact with the flexible foil structure on a backside thereof opposite the front side of the device.

The backing structure comprises a deformable material having a viscous response in a critical range. This critical range is defined for a given front impact event by the pressure threshold and the stretching threshold. The critical range is chosen between an upper threshold which allows the backing structure to deform so as to keep a pressure exerted on the flexible foil structure as a result of the impact lower than the pressure threshold; and a lower threshold, which keeps the deformation of the backing structure within a maximum deformation range so as to prevent an overstretching of the flexible foil structure beyond the stretching threshold. Thereby allowing a majority portion of an energy of the impact to dissipate by a viscous response of the backing structure.

By a viscous response we mean a response that depends on the strain rate, possibly in a complicated way. That is, the stress in the backing material is possibly a complicated function of the strain and the strain rate. In an embodiment the viscous response of the backing material is in the aforementioned critical range when the backing structure has a viscosity $\eta$ for a given thickness $d$ of the backing structure such that a ratio of the viscosity over the thickness $\eta/d$ is between 0.25 MPa·s / m and 5 GPa·s / m. This range may provide adequate impact resistance for a typical impact and stress tolerance of the flexible foil structure. The viscosities cited herein may be those as measured at room temperature and other standard environmental conditions.

The currently disclosed device provides an improved impact resistance by a combination of a flexible foil structure and an underlying backing structure having viscous properties such that it may deform upon impact while supporting the flexible foil structure, without letting a too high pressure of the impact build up in the flexible foil structure or letting the flexible foil structure overstretch. The optical layer and/or electronics constitute the critical components that are comprised in a flexible foil structure. Because the backing structure allows the flexible foil structure to deform upon (front) impact in a controlled manner, the energy of the impact is not dissipated in the critical components but instead passed to the backing structure that lies behind.

In an embodiment the device may be a display device wherein the electronics are arranged for driving and/or controlling a display effect in the optical layer. Because the backing structure is provided behind the optical layer the view on the optical layer is not obscured, and the display device does not suffer from a deterioration of its visual quality as viewed by a user.

An advantage of such a configuration is that the backing structure may be formed by materials that would not be suitable if they were placed in front of the optical layer, e.g. because they are non-transparent. Accordingly, in an advantageous embodiment the backing structure may comprise a microcellular foam layer with the desired viscous properties. The micro-cellular nature of the foam layer may help in a dissipation of the impact energy, e.g. through friction losses upon compression. Furthermore the foam layer may have a lower weight than conventional solid protective materials, thus leading to an overall reduction of device weight.

In another embodiment the device may be a solar cell device, wherein the optical layer comprises photo-voltaic cells and the electronics comprise connections to transmit electric energy generated by the photo-voltaic cells.

It is to be appreciated that similar arguments hold for solar panels as for display devices. Currently most commercially available solar panels are produced on glass. For ease of mounting and reduced cost of transportation there is a need for low weight solar panels. At the same time solar panels should be able to withstand outdoor conditions, including object dropping on the panels, such as hail. Another requirement of solar panels is optimal efficiency. To reach optimal efficiency it is important to have an efficient light path from the light source to the energy conversion layers in the solar panel.

Conventionally, solar panels may be reinforced at the front side, resulting in increased weight, cost and reduced efficiency. Accordingly, there is also a need for a solar cell device with an improved impact resistance that does not suffer from the aforementioned disadvantages. These and other needs may be met by a device according to the first aspect.

Another application would be in OLED lighting, e.g. OLED panels that are attached to a wall and need to be protected against impact events may be provided as a device according to the first aspect.

In a second aspect there is provided a method for providing a device that is resistant to a given front side impact. In a step there is provided a flexible foil structure comprising an optical layer and electronics for controlling and/or interfacing with the optical layer. In another step a pressure threshold and a stretching threshold of the flexible foil structure is determined, below which thresholds the optical layer and electronics are not damaged. In another step a backing structure is selected and brought in mechanical contact with the flexible foil structure on a backside thereof opposite (away from) side of the front side impact. The backing structure comprises a deformable material having a viscosity in a critical viscosity range, similar as described above for the first aspect

Through the method according to the second aspect an impact resistant device may be produced with similar advantages as described above.

Further advantages and areas of applicability of the present systems and methods will become apparent from the detailed description provided hereinafter. It should be understood that the detailed description and specific examples, while indicating exemplary embodiments of the method and system for automatic posture evaluation, are intended for purposes of illustration only and are not intended to limit the scope of the invention.

BRIEF DESCRIPTION OF THE DRAWINGS

These and other features, aspects, and advantages of the apparatus, systems and methods of the present invention will become better understood from the following description, appended claims, and accompanying drawings. The drawings are not necessarily to scale unless indicated. Relative scales of objects, layers and components in the drawings may be exaggerated while some details may be omitted for illustrative purposes. In the drawings:

FIG 1 shows an illustration of a Kelvin-Voigt model.
FIG 2 illustrates an impact event.
FIG 3 shows model and numerical calculations of an impact event.
FIG 4 illustrates parameters of an analytic impact model.
FIG 5 illustrates an embodiment of a device according to the first aspect being hit by an impact event.
FIG 6 illustrates an embodiment of a flexible display device according to the first aspect.
FIG 7 illustrates an embodiment of a rigid display device according to the first aspect.
FIG 8 illustrates an embodiment of a solar cell device according to the first aspect.
FIG 9 illustrates an embodiment of a device according to the first aspect being touched by a stylus.
FIG 10 illustrates a detailed view of a stack of layers of an embodiment of a display device.
FIG.11 illustrates a detailed view of a stack of layers of an embodiment of a solar cell device.
FIG 12 shows stress-strain curves of a backing structure material at different strain rates.

DETAILED DESCRIPTION

The following description of certain exemplary embodiments and model equations is merely exemplary in nature and is in no way intended to limit the invention, its application, or uses. In the following detailed description of embodiments of the present systems, devices and methods, reference is made to the accompanying drawings which form a part hereof, and in which are shown by way of illustration specific embodiments in which the described devices and methods may be practiced. These embodiments are described in sufficient detail to enable those skilled in the art to practice the presently disclosed systems and methods, and it is to be understood that other embodiments may be utilized and that structural and logical changes may be made without departing from the spirit and scope of the present system. The following detailed description is therefore not to be taken in a limiting sense, and the scope of the present system is defined only by the appended claims. Moreover, for the purpose of clarity, detailed descriptions of well-known devices and methods are omitted so as not to obscure the description of the present system.

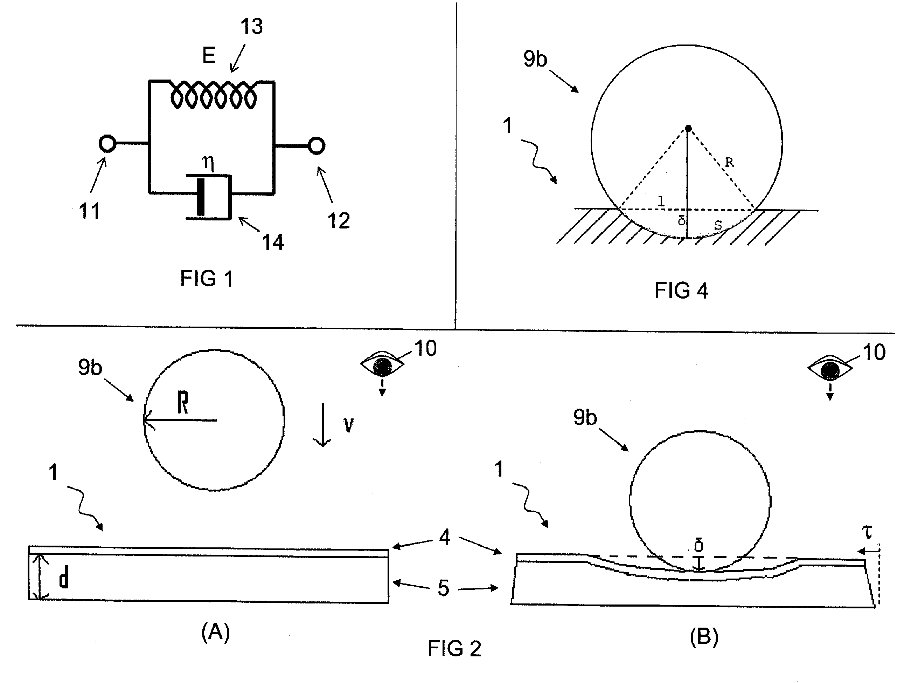

In the following passages belonging to FIGs 1 - 4, an analytical approach is provided to possibly aid an estimation of the material properties that may be required to provide a certain degree of impact resistance to a device. While this explanation may be considered illustrative, the invention is not limited to the specific models and calculations provided therein. E.g. other analytic methods, and/or numerical or empirical approaches may provide similar or different information on required or desired material properties for the flexible foil structure and/or the backing structure.

An ultra-thin flexible foil structure, e.g. comprising an optical layer, can allow for relatively large out-of-plane deformations by using its ability to bend. When a device, such as a display device, has an optical layer comprised in such a flexible foil structure, this makes it possible to dissipate energy over a longer indentation length when a projectile hits the device. This reduces the loads on the internal layers and structures that make up the device and which are prone to damage. Using the right padding material, the impact deformation can be guided in such a way that it covers a large area, further reducing the loads and impact waves that run through the fragile structures in the device. As was noted earlier, these arguments may apply similarly for display devices and solar cell devices.

Since normal displays are usually rigid, there is not much room for such a display to accommodate the impact blow of a projectile by means of (reversible) out-of-plane deformation. The rigidity of these displays means that the energy of the projectile has to be dissipated over a very limited indentation path, leading to very high loads and strains which cause very violent impact waves that run through the display stack and over its surface. The situation may be worsened by the fact that often very brittle materials are being used (e.g. glass) that can withstand only very limited strains before breaking.

An advantage of the currently disclosed display device is an at least lowering of the restrictions on out-of-plane deformation of the display and a way to guide these deformations in such a way that damage can be avoided. This means that the impact energy can be spread over a large area and dissipated over a relatively long indentation path (i.e. depth of the indentation made by the projectile).

The restrictions on out-of-plane deformation of the display can e.g. be lifted by using an ultra-thin display. In such a display all layers can be very close to the neutral line which means that there will only be moderate strain and stress levels in these layers when the display bends. This means that a very thin display can accommodate large over-all deformations without material failure (e.g. plastic deformation).

In plate theory the *flexural rigidity* D of a plate, i.e. the parameter that describes how rigidly a plate behaves when it is being bent, is given by

$$(1) \quad D = \frac{Eh^3}{12(1-v^2)}.$$

Here E denotes the elastic modulus (which will be used hereinafter as synonymous to the Young's modulus) of the material of which the plate is made, v denotes the Poisson ratio of the material, and h denotes the thickness of the plate. It is noted that the flexural rigidity scales with the third power of the thickness of a plate. This means the flexural rigidity of a very thin plate (e.g. in the order of 100$\mu$m) will be small, i.e. it will bend very easily. Although an ultra-thin display may not be a plate of homogeneous material (e.g. it may consist of a stack of very thin layers of different material), an effective flexural rigidity can be defined for the display stack and the above conclusions carry over to this case. This means that not only may an ultra-thin display accommodate a large deformation without material failure, it may also be very easy to bend it to a large deformation.

It is noted, however, that the boundary conditions posed by an impacting projectile may not be solved by bending alone. The surface area of a display that has deformed out-of-plane may be larger than the in-plane display. This means that apart from bending, the display may also have to stretch (or the underlying material will may to shear: see e.g. FIG 2). Another reason for the display to stretch is when the boundary conditions imposed by the impacting projectile are such that the display has to curve in both surface directions; this may require that the display stretches. Stretching scales with the thickness h of the display stack, i.e. it is easy for an ultra-thin display to stretch, even though the amount of stretching it can withstand is limited.

To avoid plastic deformation of the display or breaking of its brittle internal layers (due to bending over a small radius or stretching, leading to unacceptable strain levels), not only is the display preferably able to allow for relatively large out of plane deformations, but when a projectile impacts, the resulting deformation is also preferably guided in such a way that it covers a large surface area. Spreading the impact over a large area also means that it will be easier to dissipate the energy of the impact (by the backing structure or padding material at the back of the flexible foil structure), leading to smaller loads. The backing structure at the back of the flexible foil structure preferably performs both these functions, i.e. define the area of deformation to be large and dissipate as much energy of the impact as possible. To maintain flexibility of the stack of backing structure and flexible foil structure together, the backing structure should preferably have a low elastic modulus when it is in normal use, i.e. when it happens not to be hit by a high velocity projectile.

The above shows that to turn an ultra-thin flexible display into an impact resistant display, the backing structure or padding material with which it is preferably combined needs to fulfill several specific requirements. The inventors currently propose to use a backing structure comprising a material that can be described by though is not limited to a *Kelvin-Voigt model* wherein the elastic modulus E is small (i.e. small spring constant) and the viscosity (i.e. the coefficient in front of the strain rate) $\eta$ is large (i.e. large dashpot):

$$(2) \quad \sigma(t) = E\varepsilon(t) + \eta \frac{d\varepsilon(t)}{dt}.$$

Here $\sigma$ is the stress, i.e. reaction pressure of the backing structure exerted on the flexible foil structure, e.g. in units of Pascal and e is the strain, i.e. a normalized (unitless) measure of deformation of the backing structure relative to a reference length, e.g. a thickness d of the backing structure in undeformed state. The elastic modulus E, also known as the Young's modulus, relates the stress $\sigma$ to the amount of strain $\varepsilon$ and may be expressed in units of Pascal (Pa). The viscosity $\eta$, also known as the dynamic or absolute viscosity, relates the stress $\sigma$ to the rate of change of the strain $\varepsilon$ and may be expressed in units of Pascal seconds (Pa s). From equation (2) a possible way may be derived to measure the viscosity $\eta$: e.g. first measure the response (i.e. the stress) at a very low strain rate to determine E; then repeat this at several strain rates and fit $\eta$ to the data (e.g. using a least squares fit).

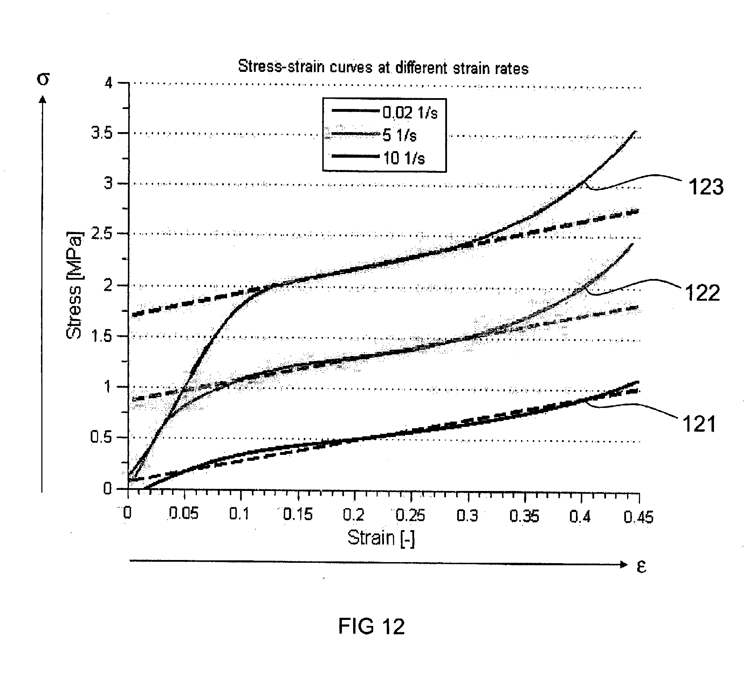

In FIG 12 it is shown how the above procedure might be performed. The Figure shows the stress ($\sigma$) versus strain (e) curves when a part of the backing structure material is compressed at three different strain rates. Curves 121, 122, and 123 correspond to strain rates of 0.02, 5, and 10 per second, respectively. Three straight lines (dashed) have been fitted through these curves (where the fit ignores the initial part of the curves). The curve 121 at the very low strain rate basically shows the elastic behavior of the material. The offsets of the three dashed lines at zero, or equivalently their relative translations to the line at the very low strain rate, are given by $\eta$ times the strain rate. Dividing these offsets by the respective strain rates and fitting (e.g. least squares) a constant line through them as a function of the strain rate then provides a possible value for the viscosity $\eta$ with which to model the backing structure.

Schematically the current model is depicted in FIG 1. The model system comprises a spring 13 and dashpot 14 that are arranged in parallel configuration between two points 11 and 12. Point 11 may relate e.g. to the impacting object while point 12 relates e.g. to a plateau on which the device is located. The model relates the time-dependent strain $\varepsilon$ applied between the points 11 and 12 to the resulting time-dependent stress $\sigma$ that is felt as a function of the elastic modulus and the viscosity of the system. Although here, a model is used of a parallel dashpot and spring other models may be possible for different materials, e.g. a configuration wherein the spring and dashpot are arranged in series or a combination of a parallel and series configuration.

When the impact velocity is very high, the material of the backing structure preferably indents very quickly, which results in a large derivative of the strain and therefore a high stress which leads to a high reaction force on the impacting projectile. That is, at high impact velocities the material may appear stiff (the dashpot is rigid). However, during normal use the velocities may be so low that the dashpot is negligible compared to the spring, i.e. the material behaves elastically and is flexible (since E is small).

The inventors have noted that foam, i.e. an elastic material with many cavities filled with air, is a material that might be described approximately by a Kelvin-Voigt model. The elastic part of the model (E) is given by the material itself and the air in the cavities makes up the dashpot: when the foam is compressed the air needs to flow out of the cavities which takes time and dissipates energy. When compressed rapidly the foam appears stiff since the air in the cavities can not leave the material quickly, whereas at low compression speeds air can readily flow out and all that remains is the elasticity of the material itself.

We now turn our attention to FIGs 2(A) and (B) which show two timeframes of a projectile 9b with radius R impacting a device 1 from a front side 10. The figure shows an embodiment of a combined system of an ultra-thin flexible foil structure 4 with a backing structure 5 which may comprise e.g. foam or some other Kelvin-Voigt damping material at the back side.

It is noted that at high impact velocities v of the projectile, backing structure 5 may behave as a stiff system and it preferably has a thickness d that is much larger than the thickness of the flexible foil structure 4. This means that in this case the backing structure 5 behaves much more rigidly than that the flexible foil structure 4. Coming back to the low flexural rigidity of the flexible foil structure 4, this means that the shape of the resulting deformation in this case may be predominantly determined by the backing structure 5, i.e. the influence of the rigidity of the flexible foil structure 4 on the shape of the deformation is negligible. Furthermore, the relative stiffness of the foam means that a relatively large area will be deformed, which is beneficial in light of energy dissipation and in light of the stresses and strains that build up in the flexible foil structure 4 due to the bending and stretching needed to accommodate the resulting deformation.

It is noted that in FIG 2(B) the backing structure may exhibit an inward motion on a top side thereof due to a shearing $\tau$ of the backing structure 5 as a result of the impact 9b pulling on the top layer 4. Such shearing $\tau$ may be beneficial to relieving some of the strain that is put on the flexible foil structure 4, since it may have to stretch less compared to a situation wherein no shearing $\tau$ occurs.

It is further noted that there is an upper limit to the stiffness the backing structure 5 preferably has (when impacted at high velocity) which is imposed by the vertical loads or maximal pressure that the flexible foil structure 4 can withstand. As mentioned before: a reaction force acts on the flexible foil structure 4 which is squeezed between the impacting projectile 9b and the backing structure 5. The maximal stress in the vertical direction will usually be present at the moment of impact and is given by

$$(3) \qquad \sigma_{max} = \frac{\eta v_0}{d}.$$

Here we have ignored the elastic term in Equation (2), and we have used that the derivative of the strain is equal to the impact velocity of the ball $v_0$ divided by d. Preferably, the material parameters $\eta$ and d of the backing structure 5 are chosen in such a way that this maximal vertical stress $\sigma_{max}$ is smaller than the critical stress $\sigma_{critical}$ at which damage appears (e.g. in the case of an electrophoretic display SiPix cups or E-Ink capsules breaking), i.e.

$$(4) \qquad \frac{\eta}{d} \leq \frac{\sigma_{critical}}{v_0}.$$

Typical values of $\sigma_{critical}$ for an optical layer (or the flexible foil structure comprising the optical layer) of a display device may be in a range of 0.1 MPa - 500 MPa. For a solar cell device this range may be higher, e.g. 1 MPa - 1000 MPa. We will now look at the impact of a projectile 9b on the flexible foil structure 4 with the backing structure 5 in more detail. The geometry of the impacting projectile 9b can be described for specific impacts by the two principal radii of curvature at the point of impact. For reasons of simplicity it is assumed in the current calculation that these two radii are equal. This means that as far as the impact is concerned, the projectile looks like a ball with radius R. Apart from the radius R there are four more important parameters: two concerning the impacting projectile, i.e. its mass m, its impact velocity v0 (or equivalently, mass m and dropping height h), and two concerning the foam, i.e. its viscosity $\eta$ and its thickness d.

Newton's second and third laws (the reaction force is given by Equation (2), where we ignore the elastic term) applied to the ball, lead to the following equation of motion

$$(5) \qquad m\frac{d^2\delta}{dt^2} = -\frac{\eta}{d}\frac{d\delta}{dt}A(\delta).$$

Here $\delta$ is the indentation depth and $A(\delta)$ is the contact area between the ball and the foam (+ flexible foil structure 4). We assume that A depends on the time only through $\delta$. We denote by B a primitive function of A and rewrite Equation (4) as

$$(6) \qquad \frac{d}{dt}[\frac{d\delta}{dt} + \frac{\eta}{md}B(\delta)] = 0.$$

Integration of Equation (6) leads to

$$(7) \qquad \frac{1}{1-\frac{\eta}{mdC_1}B(\delta)}\frac{d\delta}{dt} = C_1.$$

Here $C_1$ is an integration constant that will be determined later on from the initial conditions. Inspired by the Hertz indentation theory we assume that $A(\delta) = \pi\delta R$ and we rewrite Equation (7) to

$$(8) \qquad \frac{1}{1-\frac{\eta\pi R}{2mdC_1}\delta^2}\frac{d\delta}{dt} = C_1.$$

Defining $x := \delta\sqrt{(\eta\pi R/(2mdC_1))}$, leads to

$$(9) \qquad \frac{1}{1-x^2}\frac{dx}{dt} = \sqrt{\frac{\eta\pi RC_1}{2md}}.$$

Using the identity

$$(10) \qquad \frac{1}{1-x^2} = \frac{1}{2}(\frac{1}{1+x} + \frac{1}{1-x}),$$

Integrating Equation (9), we find

$$(11) \quad \log \left| \frac{1+x}{1-x} \right| = \sqrt{\frac{2\eta\pi RC_1}{md}} t + C_2$$

Here $C_2$ is another integration constant. Exponentiation and the initial condition $x(0) = 0$ shows that $C_2=0$. Some elementary manipulations then lead to

$$(12) \quad \delta(t) = \sqrt{\frac{2mdC_1}{\eta\pi R}} \frac{\exp(\sqrt{\frac{2\eta\pi RC_1}{md}}t) - 1}{\exp(\sqrt{\frac{2\eta\pi RC_1}{md}}t) + 1}.$$

Using the initial condition $\delta'(0) = v_0$, we find $C_1=v_0$. This means that the indentation depth $\delta$ versus time $t$ is given by

$$(13) \quad \delta(t) = \sqrt{\frac{2mdv_0}{\eta\pi R}} \frac{\exp(\sqrt{\frac{2\eta\pi Rv_0}{md}}t) - 1}{\exp(\sqrt{\frac{2\eta\pi Rv_0}{md}}t) + 1}.$$

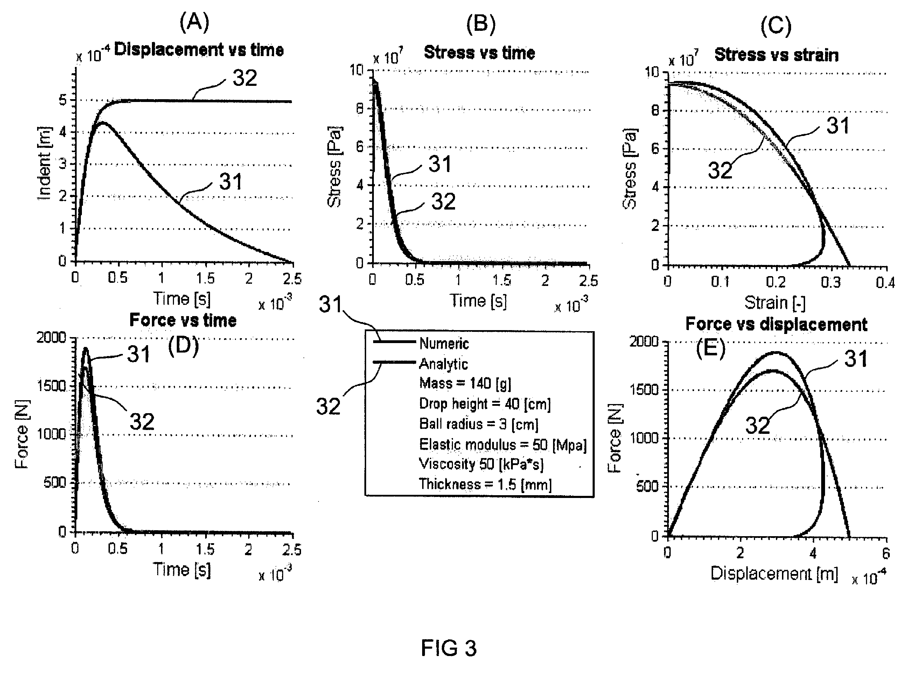

FIG 3 shows five different graphs (A)-(E) of a typical impact event, wherein, the curves 32 represent the current analytic model, while curves 31 represent a numeric model in which the elastic term has been incorporated in a simplified way. Equation (13) is plotted as curve 32 in graph (A) of FIG 3. Since we have omitted the elastic term, the ball does not rebound but reaches an asymptotic limit. Comparing the analytic model to the numeric model in graph (A) shows that the asymptotic value of Equation (13) gives a good rough estimate of the true maximal indentation:

$$(14) \quad \delta_{\max} = \lim_{t \to \infty} \delta(t) = \sqrt{\frac{2mdv_0}{\eta\pi R}}.$$

This also shows that the thickness d of the backing structure is at a minimum equal to

$$d_{\min} = \frac{2mv_0}{\eta\pi R}$$

This means we find the following constraint on the product of $\eta$ and d

$$\eta d \geq \frac{2mv_0}{\pi R}$$

A material such as micro-cellular foam that comprises many micro cavities may have an increase in its Young's modulus when the indentation is at a point where all the cavities have been pressed completely flat (all the air has left the cavities). This can be advantageous: At the point of increase in the Young's modulus the velocity of the impacting projectile will already be reduced substantially, which means that the increase in elastic reaction force on the flexible foil structure 4 could still be small enough such that the pressure in the flexible foil structure 4 stack does not exceed the pressure threshold. In the later part of the indentation the projectile is then decelerated by the elastic term which could in turn prevent the projectile from actually hitting the rigid underground.

A second advantage is that when the device is touched by a finger or stylus (velocities are very low, i.e. the viscous term is negligible) at some point the foam will react with a much larger E modulus such that the indentation does not become too deep. Preferably, the increase in the Young's modulus occurs before a stretching threshold of the flexible foil structure is exceeded. Typical indentation depths before the flexible foil structure might be damaged might be 0-2 mm. Accordingly, in an embodiment the backing structure has an increase in its Young modulus at an indentation depth less than 2 mm to prevent this damage. This increase should be sufficient to decelerate the impacting object, e.g. the increase in the Young's modulus may be at least 10%, preferably 50% or more.

Suppose the backing structure is a microcellular foam of a density p and suppose the material of which the foam structure is made has a density po. If it is not desirable that the projectile indents the foam to the point where the microcellular structure has been pressed flat, then the minimal thickness of the foam might be taken as

$$d_{min} = \frac{\rho_0^2}{(\rho_0 - \rho)^2} \frac{2mv_0}{\eta \pi R}$$

This would lead to the following constraint on the product of $\eta$ and d

$$\eta d = \frac{\rho_0^2}{(\rho_0 - \rho)^2} \frac{2mv_0}{\pi R}$$

The second graph (B) of FIG 3 shows that the maximal stress is indeed reached at t=0 (see also Equation (3)). The enclosed areas in the stress-strain and force-displacement graphs (C) and (E) are a measure for the dissipated energy in the two models. The above shows that the analytic model is a very accurate description at high velocities.

When the indentation is maximal, the velocity of the ball is zero. This means that only the elastic term in Equation (2) is relevant. Since the modulus E of the foam is very low, the profile of the indentation will closely follow the surface of the ball, see FIG 4. This leads to stretching of the flexible foil structure 4 which must remain below a critical value $\varepsilon_{critical}$. Typical values for $\varepsilon_{critical}$ for flexible display foils may be in a range of 0.1% - 5 %. We find the following expression for the strain:

$$(15) \quad \varepsilon = \frac{s - l}{l} = \frac{2R \arccos(\frac{R - \delta}{R}) - 2\sqrt{2\delta R - \delta^2}}{2\sqrt{2\delta R - \delta^2}}.$$

Since $\delta$ is small we can expand the above formula in a Taylor series around $\delta$=0. Taking terms up to first order in $\delta$ gives

$$(16) \quad \varepsilon \approx \frac{\delta}{3R}.$$

Using Equation (14) this leads to the following constraint on $\eta/d$

$$(17) \quad \frac{\eta}{d} \geq \frac{mv_0}{4.5\pi R^3 \varepsilon_{critical}^2}.$$

Equations (4) and (17) constrain our design parameter $\eta/d$. Note that apart from stretching of the flexible foil structure 4, there will also be some shearing $\tau$ of the foam which means that the flexible foil structure 4 does not have to stretch as much (due to the shearing flexible foil structure 4 material is translated towards the deformation). This relaxes Inequality E17 somewhat and the critical ranges may consequently be larger than what may follow from these equations.

It is noted that from US 2010/0253604 an electronic apparatus comprising a flexible display with pressure spreading means is known. This known apparatus comprises a back surface provided with an adhered layer of *elastic material* for dissipating external pressure applied to the front surface by pointing device such as a finger or stylus, i.e. relatively slow impressions of the apparatus. No mention is made of a desired viscous or strain rate dependent response of the back surface. It is currently recognized that a viscous response of the backing structure may lead to a significantly reduced pressure in the flexible foil structure compared to an elastic response.

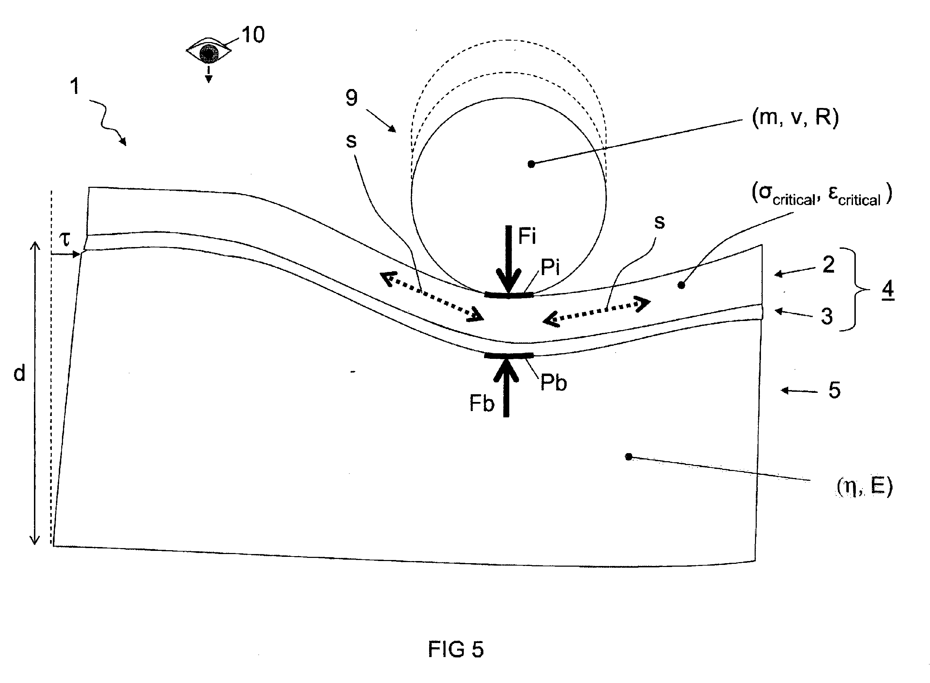

In the following passages belonging to FIGs 5-9, a more detailed overview is provided of several embodiments of an impact resistant foil device. Relative scales of objects, layers and components may be exaggerated while some details may be omitted for illustrative purposes.

FIG 5 shows a foil device 1 comprising an optical layer 2, electronics 3, and a backing structure 5. The optical layer is visible from a front side 10 of the device 1, indicated schematically by an eye. The electronics 3 are arranged for controlling and/or interfacing with the optical layer 2. The optical layer 2 and electronics 3 are comprised in a flexible foil structure 4.

The flexible foil structure has a certain pressure threshold $\sigma_{critical}$ and a certain stretching threshold $\varepsilon_{critical}$ which may easily be measured e.g. by taking a number of test foils and applying a variable pressure and/or stretching until a point of breakage. The thresholds are defined such that when a pressure Pi, Pb applied to the flexible foil structure 4 stays below the pressure threshold $\sigma_{critical}$ and the flexible foil structure is not stretched beyond the stretching threshold $\varepsilon_{critical}$, the optical layer 2 and electronics 3 comprised in the flexible foil structure 4 remain undamaged. These thresholds $\sigma_{critical}$, $\varepsilon_{critical}$ may depend on e.g. the constructional properties of the constituent layers.

The backing structure 5 is in mechanical contact with the flexible foil structure 4 on a backside thereof, i.e. opposite the front (viewing) side 10 of the device 1. The backing structure comprises a deformable material of thickness d (in undeformed state). The deformable material has a viscosity $\eta$ in a critical viscosity range. Due to the mechanical contact, a front impact event 9 is passed by the front lying flexible foil structure 4 to the backing structure that lies behind.

Preferably, the mechanical contact between the flexible foil structure and the backing structure is provided by a direct contact between the flexible foil structure and the backing structure. Alternatively, the term "mechanical contact" may be interpreted more broadly as any direct or indirect contact wherein a mechanical deformation of the flexible foil structure is mediated to backing structure and results in a corresponding deformation of the backing structure. An indirect mechanical contact may e.g. be established by intermediate (flexible) layers arranged between the flexible foil structure and the backing structure.

The term 'flexible' as used herein may in general applications refer to the fact that the flexible foil structure can be bent repeatedly over a radius of 50 cm or less and in the case of mobile consumer applications 'flexible' may mean 50 mm or less and for rollable or foldable applications 'flexible' may mean 10 mm or less, and preferably even 4 mm or less without the optical layer and/or electronics comprised therein losing essential functionality. Alternatively, or in conjunction a structure or plate may be considered flexible if it has a flexural rigidity (see Equation (1)) smaller than 500 Pa·m$^3$ (roughly corresponding to a possible bending radius of 50 cm), preferably smaller than 0.5Pa·m$^3$ (roughly corresponding to a possible bending radius of 50 mm), most preferably smaller than 0.005 Pa·m$^3$ (roughly corresponding to a possible bending radius of 10 mm). In particular when the flexible foil structure has a flexural rigidity in a low range (i.e. it is very flexible), e.g. D = 0.1- 50 mPa·m$^3$, the foil may provide a desirable accommodation to a typical impact event.

It is to be appreciated that in the current discussion wherever there is mention of a viscous response of the backing material, this statement may be generalized to a visco-elastic response of the backing material and/or the total system including the flexible foil structure 4. However, it is noted that for a preferred embodiment a material of the backing structure is chosen such that, at the moment of impact and at relevant impact speeds, it has a much higher viscous response, e.g. proportional to the viscosity n of the material, than elastic response, e.g. proportional to the Young's modulus E of the material for the currently chosen materials. It is noted however that when the backing structure is compressed, e.g. by the impact, the elastic response may increase to become a dominant factor in the forces exerted on the flexible foil structure. The elastic response may also play an important role, e.g. during normal use when the flexible foil structure is impressed slowly e.g. by a finger or stylus.

In an embodiment, the backing structure 5 has a viscous response in a critical range which is defined for a given front impact event 9 by the before mentioned pressure threshold $\sigma_{critical}$ and stretching threshold $\varepsilon_{critical}$ of the flexible foil structure 4. On the one hand the backing structure 5 should preferably have a low enough viscous response such that during impact the backing structure can deform enough to keep a pressure Pb, exerted on the flexible foil structure as a result of the impact 9 lower than the pressure threshold $\sigma_{critical}$ for the flexible foil structure 4. On the other hand the viscous response of the backing structure 5 is preferably high enough such that the deformation of the backing structure 5 is kept within a maximum deformation range to prevent an overstretching of the flexible foil structure 4 beyond

the stretching threshold $\varepsilon_{critical}$. Finally, the viscous response of the backing structure 5 is preferably such that it may dissipate a majority portion of an energy of the impact.

Looking in more detail at the impact event 9, it is noted that the impact may be defined e.g. by an impacting ball of mass m, velocity v, and radius R (not necessarily to scale here). The mass m and velocity v determine a momentum and/or energy of the impact, while the radius R determines a surface over which this momentum and/or energy is applied to the device. Through the front impact event 9, a force or pressure is applied to the front of the device 10, on which side the flexible foil structure 4 is provided. It is further noted that due to the impact a strain in the flexible foil structure may be partly alleviated by the shearing $\tau$ of the backing structure.

A test to see if a device is impact resistant may be to provide a front side impact that is equivalent to a ball of diameter 7 cm and mass 160 g being dropped on the front side of the device from a height of 40 cm.

Other definitions of front side impacts may be (depending on the situation) e.g.:

- for outdoor condition, e.g. for a solar cell device: a resistance to extreme hail conditions wherein the device should withstand an impact equivalent to a ball with radius=30mm, mass = 104 g, and impact velocity= 15m/s;
- for rough environments: steel ball radius =25mm, mass =510g, impact velocity =5 m/s;
- for less rough environments: billiard ball radius = 29.5 mm, mass = 139g, impact velocity = 5m/s or a steel ball radius 9.5mm, mass 28g and velocity 2.5 m/s;
- in daily use, e.g. an elbow that bumps into the device, e.g. r= 10mm, mass = 500 g, impact velocity 0.3 m/s.

In an embodiment the device may be classified as "impact resistant", when it can at least withstand a front side impact event that is equivalent to an object of mass 100 grams, radius 10 cm and impact velocity of 1 m/s. For typical impact conditions of the above kinds, the viscosity response can be in the critical range when the backing structure has a viscosity ($\eta$) for a given thickness (*d*) of the backing structure such that a ratio of the viscosity over the thickness ($\eta/d$) is between 0.25 MPa·s / m and 5 GPa·s / m.

On the one hand, the momentum of the ball at the time of impact determines the force Fi of the impact event on the flexible foil structure. Depending on the radius of the ball this force Fi is spread over a corresponding contact surface resulting in a certain impact pressure Pi. Due to its flexibility, the impact force Fi may be mediated through the foil structure 4 to the backing structure 5 which is in mechanical contact therewith. As a result of this force the backing structure 5 may deform depending on its viscosity $\eta$. During deformation, the backing structure 5 may exert a counter force Fb onto the foil structure 4, which may be spread out over a certain area resulting in a pressure Pb. It is to be appreciated that the effective pressure felt by the flexible foil structure 4 is largely determined by the counter pressure Pb exerted by the backing structure 5. E.g. without the backing structure 5 the flexible foil structure 4 would be freely deformable and there would be no pressure build-up. To keep this effective pressure on the flexible foil structure below the critical pressure $\sigma_{critical}$, for a given impact event 9, the backing structure 5 should be deformable enough, i.e. have a low enough viscosity n and/or elasticity E, such that this pressure does not build up beyond the threshold pressure during the impact event 9.

On the other hand, the velocity and/or mass of the impact event 9 may determine the total amount of stretching s that the flexible foil structure 4 undergoes during the impact event 9. The impact should preferably be countered by a high enough viscosity $\eta$ of the backing structure 5 to prevent an overstretching and possible rupturing of the flexible foil structure 4. It is noted that a total maximum deformation of the backing structure may be determined by the amount of energy that is dissipated by the deformation. In particular, when the impacting object comes to a standstill, all kinetic energy of the impact is either dissipated by the viscous response or stored as potential energy e.g. due to the elastic response. Preferably the elastic response at least initially is kept minimal to prevent additional force acting on the flexible foil structure at the time of impact. Later on the elastic response may grow when the velocity of the impact event has partly diminished, e.g. as the backing structure becomes more compressed.

It is noted that a larger velocity and/or mass of the impact event 9 means that more energy has to be dissipated by the device 1. This energy is preferably not dissipated in a stretching, bending/shearing, and/or compression of flexible foil structure 4. It is therefore desired that a majority of energy of the impact, i.e. more than 50%, preferably more than 80% of the impact energy be dissipated by a viscous response of the backing structure 5. In this way only a minor portion, of the impact energy will be dissipated and/or temporarily stored (e.g. due to an elastic response of the foil structure) in the flexible foil structure 4 thus preventing a possible damaging of the optical layer 2 and/or electronics 3 comprised therein.

It is noted that for a desired dissipation effect, not only the viscosity q, but also the thickness d of the backing structure 5 (before impact) may be important. Accordingly, in an embodiment, the viscosity q and thickness d of the backing structure 5 are preferably chosen such that a ratio of the viscosity over the thickness ($\eta/d$) is between 0.25 MPa·s / m and 5 GPa·s / m. In terms of absolute viscosity $\eta$ the backing structure preferably has a viscosity in a range between 250 Pa·s and 5 MPa·s This may provide on the one hand sufficient possibility to dissipate the energy of a typical impact event 9 and on the other hand provide sufficient viscous flow to keep the pressure on the flexible foil 4 below the threshold pressure $\sigma_{critical}$ for such an impact event 9.

It is to be appreciated that whereas in the current figure the optical layer 2 and electronics 3 are shown in separate layers, these may also be integrated in a single layer. Alternatively, electronics 3 may be present on both sides of the optical layer 2 or alternatively still, only on the front side 10. An example of electronics that may be present on the front side 10 may be e.g. transparent electrodes such as may be used to apply a voltage to the front side 10 of the optical layer 2.

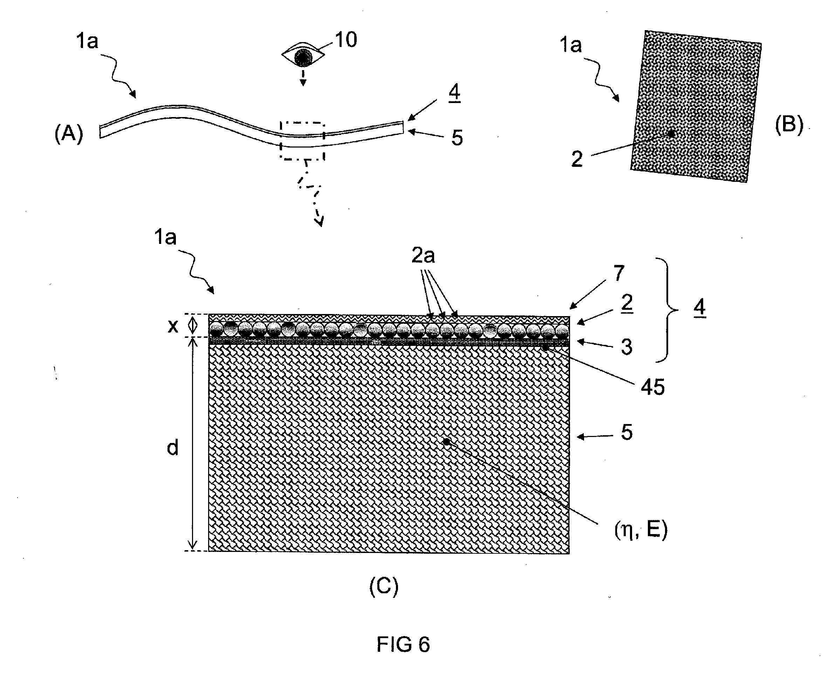

FIGs 6(A)-(C) shows three views of an embodiment of an impact resistant foil device that may operate as a display device 1a.

FIG 6(A) shows a side view of the display device 1a comprising flexible foil structure 4 on a front side 10 and a backing structure 5 in mechanical contact to the flexible foil structure.

In the currently shown embodiment, the display device 1a as a whole is flexible. This may be accomplished e.g. by providing a flexible backing structure 5, preferably a backing structure 5 that is at least as flexible as or more flexible than the flexible foil structure 4. Accordingly, in a preferred embodiment, the backing structure in undeformed state (i.e. without applied external forces) has an elastic modulus E that is at least an order of magnitude less than an elastic modulus E of the flexible foil structure 4. This has as an advantage that when the display device 1a is bent, e.g. during normal use, the backing structure will easily deform, i.e. without much force applied, and consequently only minimal strain will be exerted on the flexible foil structure. It is noted that the elastic modulus might go up when the material has been compressed sufficiently; the modulus might then no longer be an order of magnitude less than the modulus of the flexible foil.

FIG 6(B) shows a front view of the display device 1a wherein the optical layer 2 is visible.

FIG 6(C) shows a cutout with a more detailed cross-section of FIG 6(A). The display device 1a comprises a flexible foil structure 4 and a backing structure 5. The flexible foil structure 4 comprises an optical layer 2 and electronics 3. If an optional protecting front layer 7 is used, this layer preferably has a flexibility such that a flexibility of the flexible foil structure remains within acceptable ranges for mediating front impacts. The optical layer in the shown embodiment comprises capsules 2a which may provide a desired display effect under control of the electronics, e.g. depending on a voltage applied over the capsules by the corresponding electronics. To this end the electronics may employ e.g. thin film transistors (TFTs) or other means for switching the display effect. It is noted that pixels may be defined e.g. in the electronics layer while the optical layer does not have a pixilated structure. In such a case a plurality of capsules may be driven by a single transistor. Alternatively, each capsule can be driven by a single TFT.

In an embodiment, the capsules 2a may comprise e.g. an electronic ink such as from E Ink Corporation. Circuitry or electronics 3 to drive displays, such as electrophoretic displays, is well known, such as described in WO2008/05420 and WO2008/054210 to Markvoort, each of which is incorporated herein by reference in its entirety. The capsules may e.g. comprise black and white particles (not visible in the figure) which are positively or negatively charged. Depending on a polarity of the applied voltage over the capsules, either the white or the black particles may float to the visible front surface 10 of the display device 1a. It is noted that the electronics 3 may encompass e.g. a transparent electrode on front side of the optical layer.

An advantage of an electrophoretic optical layer is that it can be very thin, e.g. thickness x is typically on the order of 100-150 pm or smaller. This means the flexural rigidity (see Equation (1)) will be very small, i.e. it will bend very easily and it is very flexible. However, the invention is not limited to electrophoretic displays and may be used in combination with flexible foil structures comprising any optical layer and/or electronics having sufficient flexibility. E.g. it may also be possible to provide a thin flexible sheet of (organic) light emitting diodes ((O)LEDs) or vertical-cavity surface-emitting lasers (VCSELs) and corresponding circuitry. Alternatively or in combination, e.g. a liquid crystal display (LCD) array may be provided on a flexible foil. In short any (passive/active) optical layer or combination of optical layers and/or corresponding electronics that may be comprised in a flexible structure and that is capable of providing a desired display effect may benefit from the current teaching to provide an impact resistant display device.

To provide a desired flexural rigidity, the flexible foil structure has a thickness x that is preferably less than 1 cm, more preferably less than 1 mm, even more preferably less than 200 $\mu$m, most preferably in a range between 50-150 pm or less, e.g. 110 $\mu$m. It is noted that when the thickness x of the foil structure 4 becomes smaller, the foil may become more fragile.

To provide a desired sturdiness to the display 1a, and to provide sufficient possibility for viscous dissipation, the backing structure 5 should not be too thin. Accordingly, the backing structures should preferably have a thickness d of 200 $\mu$m or more, preferably 500 $\mu$m or more, most preferably 1500 $\mu$m or more, e.g. 1-3 mm. On the other hand if a flexible display device 1a with low enough flexural rigidity is desired, the backing structure should also not be too thick, e.g. preferably thinner than 1 cm, more preferably thinner than 5 mm, most preferably thinner than 2 mm or even 1 mm. In this way a thin flexible display 1a may be obtained that may be used e.g. in a rollable display device.

It is noted that different thicknesses may be preferred for a display device than for a solar cell device, in particular the solar cell device may be thicker. Accordingly, in an embodiment, an impact resistant display device is provided wherein the flexible foil structure has a thickness in a range 50 $\mu$m - 300 pm and the backing structure has a thickness in a range 0.5mm - 6 mm. Also, in another embodiment, an impact resistant solar cell device is provided wherein the flexible foil structure has a thickness in a range 50 $\mu$m -3000 $\mu$m and the backing structure has a thickness in a range 0.5mm - 2 cm.

For the typical thicknesses of these embodiments, the backing structure may have a viscosity in a range between 250 Pa·s and 5 MPa·s for suitably withstanding impacts of the types previously described.

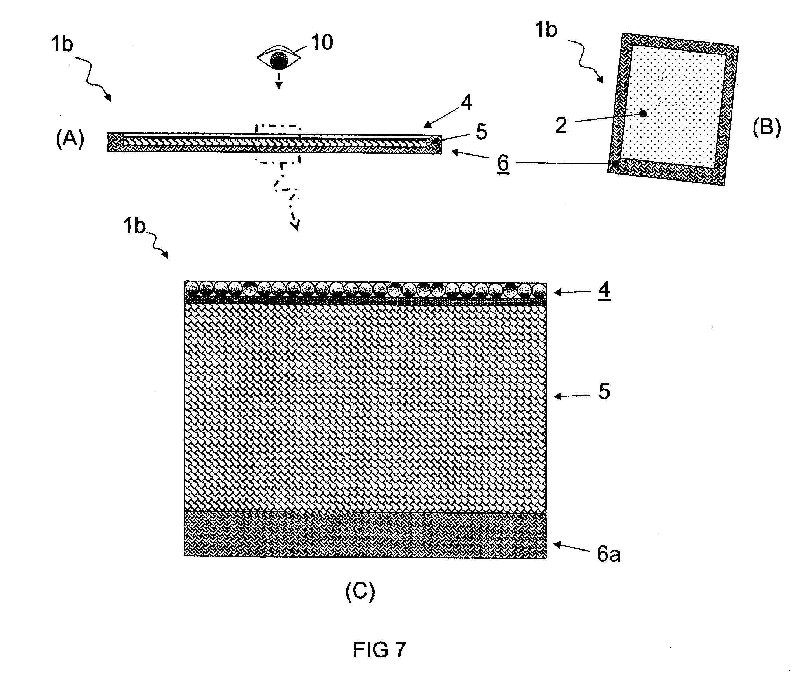

FIGs 7(A)-(C) shows three views of another embodiment of an impact resistant foil device that may operate as a display device 1b.

FIG 7(A) shows a side view of the display device 1b comprising flexible foil structure 4 on a front side 10 and a backing structure 5 in mechanical contact to the flexible foil structure 4. Furthermore there is provided a housing comprising a rigid back plate 6. The backing structure 5 is arranged between the flexible foil structure 4 and the rigid back plate 6a. The term "rigid" as used herein may refer to the fact that the back plate 6 has an elastic modulus that is at least an order of magnitude higher than an elastic modulus of the flexible foil structure 4 and/or the backing structure 5. In other words, the rigid back plate is much less flexible and will not bend as easily as the flexible foil structure 4 and/or the backing structure 5.

An advantage of the current embodiment 1b is that the resulting display may be a rigid device while still benefitting from many advantages of the current teachings. E.g. the device may be provided with impact resistance without having to shield the front side of the device with a protective glass plate. The omission of a front glass plate may be beneficial e.g. for E-books and other display devices wherein a reflective front surface may be hindering a clear view of the display, especially outdoors, thus providing a more natural reading experience.

FIG 7(B) shows a front view of the display device 1b wherein the optical layer 2 is visible as well as the part of the housing 6.

FIG 7(C) shows a cutout with a more detailed cross-section of FIG 7(A). The display device 1b comprises a flexible foil structure 4 and a backing structure 5 that may be similar as in FIG 6. Different from FIG 6, the device 1b also comprises a rigid backing structure 6a that is part of housing 6.

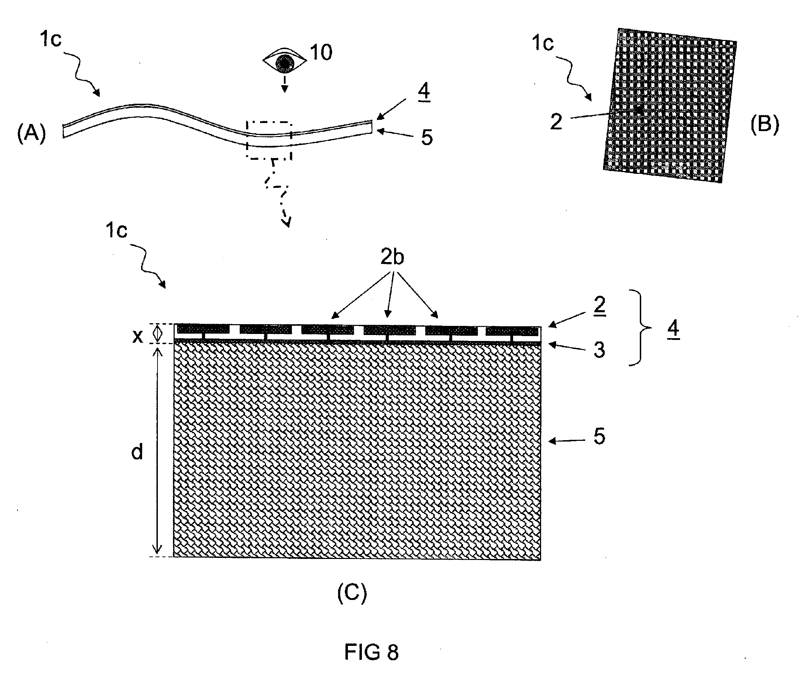

FIGs 8(A)-(C) shows three views of an embodiment of an impact resistant foil device that may operate as a solar cell foil device 1c.

FIG 8(A) shows a side view of a (flexible) sheet or foil comprising solar cells. Similar as for the display devices from FIGs 6 and 7, the foil comprises an optical layer comprised in a flexible foil structure 4 on a front side of the device. On a backside of the flexible foil structure 4, there is provided a backing structure 5 for dissipating a front impact to the device, e.g. by weather conditions such as rain or hail.

FIG 8(B) shows a front view of the device 1c wherein the optical layer 2 comprised in the flexible foil structure 4 is visible. It is to be appreciated that the optical layer is preferably visible if light of visible wavelength is to reach the optical layer to energize the solar cells.

FIG 8(C) shows a cutout with a more detailed cross-section of FIG 8(A). The solar cell device 1c comprises a flexible foil structure 4 and a backing structure 5. Like the previous embodiments, the flexible foil structure 4 comprises an optical layer 2 and corresponding electronics. Different from the display devices 1a and 1b shown in FIGs 6 and 7, the optical layer 2 of the solar cell device 1c comprises solar cells 2b. The solar cells 2b may be e.g. photo-voltaic solar cells arranged and constructed for transducing incoming light into electric energy. Methods for printing or otherwise producing thin solar cells onto a flexible sheet are known in the art. This resulting electric energy voltage may be transported by the corresponding electronics 3 that interface with the solar cells 2b. These electronics may comprise e.g. wiring to connect the solar cells to an output electrode which may in turn be connected to a battery or device to be powered (not shown).

It is thus noted that, whereas the present invention provides benefits for display devices, e.g. providing an impact protection while not obscuring a view of the optical display layer, the invention may also benefit a solar cell device. In particular, whereas in conventional solar cell devices, the solar cells may need to be protected by a protective cover, e.g. of glass, the currently proposed embodiment 1c of a solar cell device does not require such a cover. It is to be appreciated that without a possibly obscuring cover more light may reach the solar cells resulting in a higher conversion efficiency of the solar cells. Furthermore, in by not being limited by a hard cover to the solar cells, the deployment of solar cells, e.g. over irregular surfaces may be facilitated. Still, the solar cells may be sufficiently protected against impact events such as hail storms, or even people/animals walking on the solar cell surface. In combination with the currently provided impact resistance, it may be beneficial e.g. to provide an additional scratch resistant layer on top of the solar cells. Alternatively, the flexible foil structure may itself provide a measure of scratch resistance. In an embodiment of the solar cell device foil, to provide additional protection against impact events, the solar cells are of a modular design, such that even when one of the solar cells is damaged the remaining solar cells and the device as a whole may remain functional

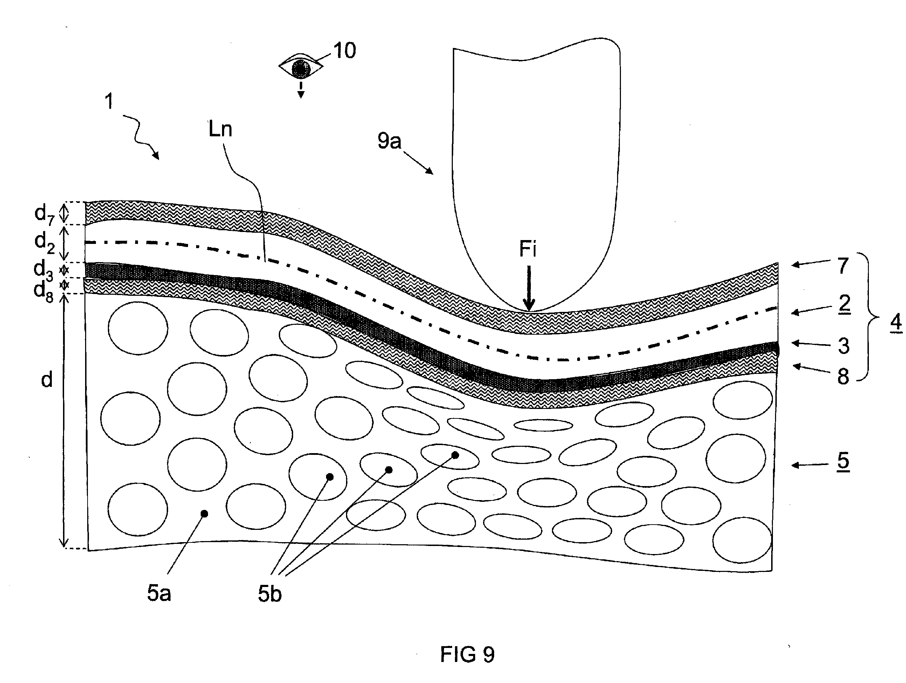

FIG 9 shows an embodiment of a foil device 1 that is being impressed by an object 9a, e.g. a tip of a stylus. The figure is not to scale. The shown foil device comprises an optical layer 2 and electronics 3, comprised in a flexible foil structure 4, and a backing structure 5 in (direct) mechanical contact therewith. As is illustrated in the current figure, in an embodiment the backing structure may comprise a micro-cellular foam layer. The foam layer may comprise e.g.

a solid deformable and/or elastic material 5a and micro-cells or pockets 5b.

The deformable material 5a may e.g. comprise polyurethane or other polymeric material. The micro-cells may comprise e.g. pockets or bubbles of air or other gas which pockets may be compressed as is illustrated in the figure. The micro cells preferably have a size, e.g. diameter, on the order of a micrometer, e.g. between 0.1 - 500 microns. The micro-cells 5b may be closed compartments or alternatively in open communication with the surroundings, wherein air or another gas may flow in and out of the backing structure. An advantage of such an open cell structure is that the frictional losses of the gas flow may help in the dissipation of energy upon compression of the backing structure. Alternatively, the material comprises a combination of open and closed cells. By tuning e.g. a size of the cells 5a and/or the gas exchange channels, a desired resulting viscosity behavior may be achieved. Preferably the micro-cellular foam layer has a relatively low density, e.g. 50 - 600 kg/m$^3$.

It is noted that when the backing structure 5 is compressed, e.g. by a force Fi as illustrated, the cells 5a may become deflated and at some point, the elastic behavior of the material 5a itself may become a dominant factor in the material response characteristic. This may also be the case e.g. if the cells are of a closed form and the gas within them becomes pressurized to a point where it starts to resist further impression. It is thus noted that the viscous and elastic behavior ($\eta$, E) of the backing structure 5 may be a function of the amount of deformation or compression of the backing structure 5. In undeformed state, i.e. without external forces acting on the device, e.g. before or at the point of impact, the viscous response (proportional to $\eta$) of the backing structure may be dominant while in fully compressed state the elastic response (proportional to E) of the backing structure 5 may be dominant. In between these two states a combination of said responses may need to be considered.

Advantageously, these responses may be tuned such that during any point of the compression the thresholds for pressure and stretching are not exceeded. Accordingly, in an embodiment an elastic response of the backing structure in compressed state is such that the flexible foil structure is prevented from overstretching e.g. beyond the stretching threshold for damage. In this way the device may also be protected from slow impressions of the flexible foil wherein a viscous response may play a minor role. Accordingly, e.g. an elastic modulus of the backing structure may become comparable to or higher than the elastic modulus of the flexible foil structure when the backing structure is partially or fully compressed.

As is illustrated in FIG 9, the flexible foil structure 4 may additionally comprise a front protection layer 7 and a back layer 8 wherein the optical layer 2 and electronics 3 are arranged between the front protection layer 7 and back layer 8. Also indicated in the figure is a neutral line or surface Ln, along which surface compression and stretching are substantially zero when the different layers are bent or pressed. Preferably, the front protection layer 7, optical layer and electronics, back layer 8, and backing structure 5 each have relative elastic moduli and thicknesses $d_7$, $d_4$, d, and $d_8$, such that a neutral plane or line Ln of a deformation of the combined layers substantially lies within the flexible foil structure 4, preferably near or through the optical layer and/or electronics. In that case, when the device is bent or compressed, e.g. during normal use, only minimal strain will be exerted on the possibly fragile components in the flexible foil structure 4.

For similar reasons, either with or without the additional layers 7 and 8, it may be advantageous to provide a backing structure 5 with an elastic modulus at least in undeformed state that is much lower than the elastic modulus of the flexible foil structure 4. In particular when the layers 4 and 5 are connected and bent, only minimal stress will be exerted on the flexible foil structure 4, because the backing structure 5 will deform more easily and not pull on the flexible foil structure 4.

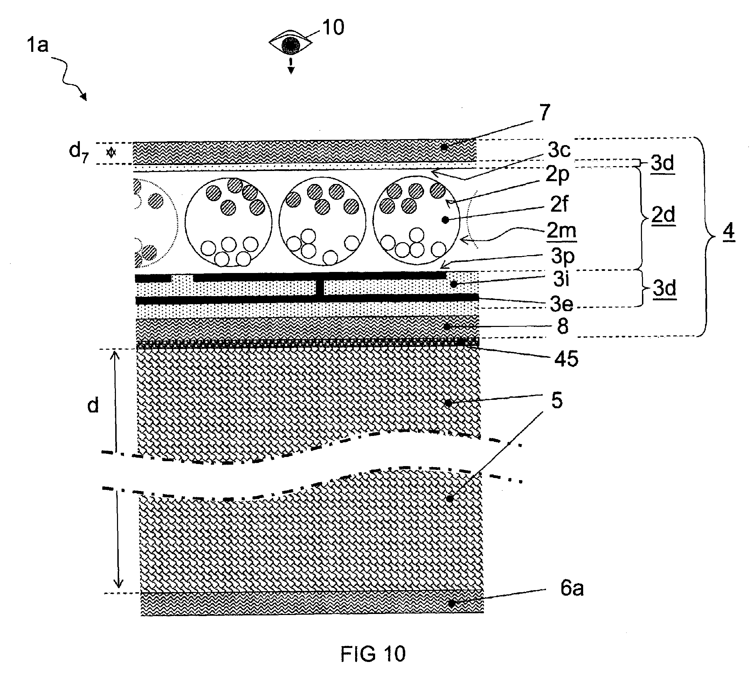

FIG 10 shows a detailed view of a stack of layers that may be present in an impact resistant display 1a. The display 1a comprises a flexible foil structure 4 and a backing structure 5 that are preferably glued together using a glue layer 45. The flexible foil structure comprises a display effect layer 2 and electronics 3. In the currently shown embodiment the display 1a is an electrophoretic display. Alternatively, other passive optical effect layers such as electrofluidic or LCD layers may also be possible.

The display effect layer 2d comprises microcapsules 2m that comprise a fluid 2f and micro-particles 2p. Micro-particles 2p of different pigmentation, e.g. black and white, are provided with opposite electrical charges (not shown).

The display driving electronics 3 comprise on a back side of the display effect layer 2d driving circuitry which may comprise a pattern of conducting or semi-conducting material 3e embedded in an isolating material 3d thus forming conducting or semiconducting tracks and circuits. Near the microcapsules 2a, the display driving electronics 3d comprise a pad or pixel electrode 3p that defines a pixel. In this case the pixel encompasses three microcapsules 2m. Other configurations wherein one or more microcapsules are associated with a single pixel are also possible. Furthermore the driving electronics 3d may comprise further components (not shown here) such as (thin film) transistors, capacitors, etc. for switching and maintaining voltages applied to the pixel electrodes 3p in a controlled manner, e.g. laid out in a matrix structure (see e.g. WO 2008/054209). The display driving electronics 3d comprise a on a front side of the display effect layer 2d a counter electrode 3c that is transparent, i.e. transmits light of visible frequencies.

The pixels, as viewed by a user, display a pigmentation depending on the pigmentation of the micro-particles that are on a front side of the display 1a. As a result of a voltage difference between the pixel electrode 3p and the counter electrode 3c an electric field may be formed through the microcapsules 2a that drives the charged micro-particles of specified pigmentation towards or away from the front side 10 of the display 1a. In this way the pixels may change color and a display effect is obtained.

The backing structure 5 has a thickness d and is shown here with a das-dotted cut line because it may be much thicker, e.g. on the order of 1- 6 mm than the flexible foil structure 4, which is e.g. on the order of 100 - 200 microns. The backing structure comprises a material such as micro-cellular polyurethane foam with a viscosity over thickness ratio in a specific range as discussed above.

On a front side 10 of the display 1a, the flexible foil structure 4 is protected by a protection layer 7 which may be comprised in the flexible foil structure 4 or provided separately. The protection layer 10 may e.g. comprise a flexible layer of PET material that is used to further shield the display effect layer 2d from scratching, moisture or other damaging influences. It is to be appreciated that due to the impact protection provided by the backing structure 5, the front protection layer 7 may have a lower thickness $d_7$, e.g. in a range 50-250 microns, than would be conventionally acceptable for commonly desired impact resistance qualifications and/or a higher impact resistance. Also provided in the flexible foil structure is an optional back layer 8, via which the flexible foil structure is glued with a glue layer 45 to the backing structure 5. On a back side of the display 1a, the backing structure 5 is provided with an optional rigid back plate 6a for providing a rigid display device such as an e-reader.

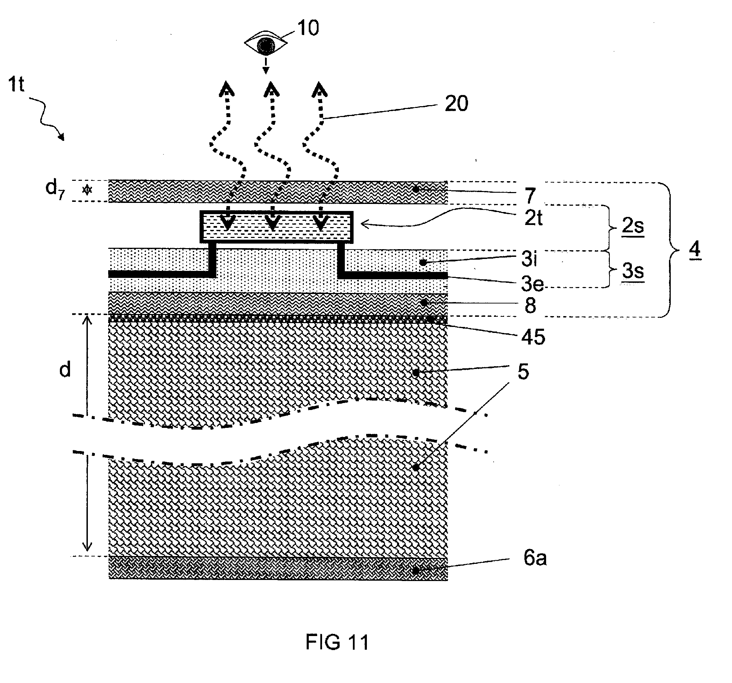

FIG 11 shows a detailed view of a stack of layers that may be present in an impact resistant device 1t wherein the optical layer 2s comprises electro-optical transducers 2t. Such a device 1t may be e.g. a display device, wherein the electro-optical transducers 2t comprise light emitting elements such as LEDs, OLEDs, VCSELs, etc., for transducing electrical energy into photonic energy 20 for providing a desired display effect. Alternatively, such a device 1t may be e.g. a solar cell device, wherein the electro-optical transducers 2t comprise photo-voltaic solar cells for transducing photonic energy 20 into electrical energy. In either case it is desired that the top layers of the device that stand between the optical transducer layer 2s and the incoming/outgoing light obscure the light as little as possible.

The interfacing/driving electronics 3s may comprise electrically conductive tracks 3e in an isolator material 3i forming electrics leads to/from the transducers 2t for transporting electric energy. Alternatively, the electronics may comprise simple wiring connecting the transducers.

In the shown embodiment, the optical transducing layer 2s and electronics are preferably sandwiched between optional front protection layer 7 and back layer 8 thus forming the flexible foil structure 4 that is glued via glue layer 45 or otherwise attached to the backing structure 5 that lies behind it. The backing structure 5 comprises a material such as micro-cellular polyurethane foam with a viscosity over thickness ratio in a specific range as discussed above.

On a front side 10 of the device 1t, the flexible foil structure 4 is protected by a protection layer 7. The protection layer 7 may e.g. comprise a flexible layer of PET material that is used to further shield the electro-optical transducers from scratching, moisture or other damaging influences. It is noted that especially OLED devices may be very sensitive to moisture influences and impacts in general. It is to be appreciated that due to the impact protection provided by the backing structure 5, the front protection layer 7 may have a lower thickness $d_7$ thinner than would be conventionally acceptable for commonly desired impact resistance qualifications and/or a higher impact resistance.

On a back side of the device 1t, the backing structure 5 is provided with an optional rigid back plate 6a for providing a rigid electro-optical transducing device such as a display or a solar cell device.

The various elements of the embodiments as discussed and shown offer certain advantages, such as providing an impact resistant foil device. Of course, it is to be appreciated that any one of the above embodiments or processes may be combined with one or more other embodiments or processes to provide even further improvements in finding and matching designs and advantages. It is appreciated that this invention offers particular advantages for display devices and in general can be applied for any system wherein a fragile (optical) circuit layer needs to be provided with a higher degree of impact resistivity while not obscuring the (optical) circuit layer from view. It is noted that also any kinematic inversions having similar functionality are considered as part of the disclosure. For example, whereas the figures may show an optical layer in front of the electronics, the electronics may also be in front or at either sides or in the same plane as the optical layer.

This description of the exemplary embodiments is thus intended to be read in connection with the accompanying drawings, which are to be considered part of the entire written description. In the description, relative terms as well as derivative thereof should be construed to refer to the orientation as then described or as shown in the drawing under discussion. These relative terms are for convenience of description and do not require that the apparatus be constructed or operated in a particular orientation. Terms concerning attachments, coupling and the like, such as "connected" and "interconnected," refer to a relationship wherein structures are secured or attached to one another either directly or indirectly through intervening structures, as well as both movable or rigid attachments or relationships, unless expressly described otherwise.

The embodiments described above may alternatively be described as an impact resistant foil devices comprising an optical layer that is visible from a front side of the device; and electronics for controlling and/or interfacing with the optical layer; wherein the optical layer and electronics are comprised in a flexible foil structure that has a pressure

threshold ($\sigma_{critical}$) and a stretching threshold ($\varepsilon_{critical}$) below which thresholds ($\sigma_{critical}$, $\varepsilon_{critical}$) the optical layer and electronics are not damaged; and a backing structure that is in mechanical contact with the flexible foil structure on a backside thereof opposite the front side of the device; wherein the backing structure comprises a deformable material having a viscosity ($\eta$) in a critical viscosity range, which critical viscosity range is defined for a given front impact event by the pressure threshold and the stretching threshold, the viscosity range chosen between a higher viscosity threshold above which the backing structure deforms as a result of the impact with a pressure exerted on the flexible foil structure higher than the pressure threshold; and a lower viscosity threshold below which the flexible foil structure stretches beyond the stretching threshold, to allow a majority portion of an energy of the impact to dissipate by a viscous response of the backing structure.

Finally, the above-discussion is intended to be merely illustrative of the present system and should not be construed as limiting the appended claims to any particular embodiment or group of embodiments. Thus, while the present system has been described in particular detail with reference to specific exemplary embodiments thereof, it should also be appreciated that numerous modifications and alternative embodiments may be devised by those having ordinary skill in the art without departing from the broader and intended spirit and scope of the present system as set forth in the claims that follow. The specification and drawings are accordingly to be regarded in an illustrative manner and are not intended to limit the scope of the appended claims.

In interpreting the appended claims, it should be understood that the word "comprising" does not exclude the presence of other elements or acts than those listed in a given claim; the word "a" or "an" preceding an element does not exclude the presence of a plurality of such elements; any reference signs in the claims do not limit their scope; several "means" may be represented by the same or different item(s) or implemented structure or function; any of the disclosed devices or portions thereof may be combined together or separated into further portions unless specifically stated otherwise; no specific sequence of acts or steps is intended to be required unless specifically indicated; and no specific ordering of elements is intended to be required unless specifically indicated.

## Claims

1. An impact resistant foil device (1) comprising

   - an optical layer (2) that is visible from a front side (10) of the device (1); and
   - electronics (3) for controlling and/or interfacing with the optical layer (2); wherein
   - the optical layer (2) and electronics (3) are comprised in a flexible foil structure (4) that has a pressure threshold ($\sigma_{critical}$) and a stretching threshold ($\varepsilon_{critical}$) below which thresholds ($\sigma_{critical}$, $\varepsilon_{critical}$) the optical layer (2) and electronics (3) are not damaged; and
   - a backing structure (5) that is in mechanical contact with the flexible foil structure (2) on a backside thereof opposite the front side (10) of the device; wherein

   the backing structure (5) comprises a deformable material having a viscous response in a critical range, which critical range is defined for a given front impact event (9) by the pressure threshold ($\sigma_{critical}$) and the stretching threshold ($\varepsilon_{critical}$), the critical range chosen between an upper threshold which allows the backing structure (5) to deform so as to keep a pressure exerted on the flexible foil structure (4) as a result of the impact (9) lower than the pressure threshold ($\sigma_{critical}$); and a lower threshold which keeps the deformation of the backing structure (5) within a maximum deformation range so as to prevent an overstretching of the flexible foil structure (4) beyond the stretching threshold ($\varepsilon_{critical}$), thereby allowing a majority portion of an energy of the impact (9) to dissipate by the viscous response of the backing structure (5), wherein the backing structure comprises a micro-cellular foam layer; and wherein the viscous response is in the critical range when the backing structure has a viscosity ($\eta$) for a given thickness (d) of the backing structure such that a ratio of the viscosity over the thickness ($\eta$/d) is between 0.25 MPa·s / m and 5 GPa·s / m.

2. Device according to claim 1 wherein the backing structure has a viscosity in a range between 250 Pa·s and 5 MPa·s.

3. Device according to one of the preceding claims where the backing structure has an increase in its Young modulus at an indentation depth less than 2 mm.

4. Device according to one of the preceding claims, wherein the device is a display device wherein the electronics are arranged for driving, controlling and/or creating a display effect in the optical layer.

5. Device according to one of the preceding claims, wherein the flexible foil structure has a thickness in a range 50 $\mu$m - 3000 $\mu$m, more particularly in a range 50 $\mu$m - 300 $\mu$m, and the backing structure has a thickness in a range 0.5 mm - 2 cm, more particularly in a range 0.5 mm - 6 mm.

6. Device according to one of claims 1 to 2, wherein the device is a solar cell device
wherein the optical layer comprises photo-voltaic cells and the electronics comprise connections to transmit electric energy generated by the photo-voltaic cells.

7. Device according to one of the preceding claims, wherein the backing structure is more flexible than the flexible foil structure.

8. Device according to one of the preceding claims, wherein the backing structure in undeformed state has an elastic modulus (E) that is at least an order of magnitude less than an elastic modulus of the flexible foil structure.

9. Device according to one of the preceding claims, wherein the flexible foil structure further comprises a front protection layer (7) and a back layer (8) wherein the optical layer and electronics are arranged between the front protection layer and back layer.

10. Device according to claim 9, wherein the front protection layer, back layer, optical layer and electronics, and backing structure each have relative elastic moduli and thicknesses such that a neutral plane of a deformation of the combined layers substantially lies within the optical layer and/or electronics.

11. Device according to one of the preceding claims, further comprising a housing having a rigid back plate with an elastic modulus that is at least an order of magnitude higher
than an elastic modulus of the flexible foil structure wherein the backing structure is arranged between the flexible foil structure and the rigid back plate.

12. Device according to one of the preceding claims, wherein the flexible foil structure has a flexural rigidity in a range of 0.1 - 50 mPa·m$^3$.

13. Method for providing a device that is resistant to a given front side impact, the method comprising

- providing an optical layer (2) and electronics (3) for controlling and/or interfacing with the optical layer (2); wherein the optical layer (2) and electronics (3) are comprised in a flexible foil structure (4);
- determining a pressure threshold ($\sigma_{critical}$) and a stretching threshold ($\varepsilon_{critical}$) of the flexible foil structure (4), below which thresholds ($\sigma_{critical}$, $\varepsilon_{critical}$) the optical layer (2) and electronics (3) are not damaged; and
- selecting a backing structure (5) and bringing the backing structure (5) in mechanical contact with the flexible foil structure (4) on a backside thereof opposite the front side impact; wherein
- the backing structure (5) comprises a deformable micro-cellular foam layer having a viscous response in a critical range, which critical range is defined for a given front impact event (9) by the pressure threshold ($\sigma_{critical}$) and the stretching threshold ($\varepsilon_{critical}$), the critical range chosen between an upper threshold which allows the backing structure (5) to deform so as to keep a pressure exerted on the flexible foil structure (4) as a result of the impact (9) lower than the pressure threshold ($\sigma_{critical}$); and a lower threshold which keeps the deformation of the backing structure (5) within a maximum deformation range so as to prevent an overstretching of the flexible foil structure (4) beyond the stretching threshold ($\varepsilon_{critical}$), thereby allowing a majority portion of an energy of the impact to dissipate by a viscous response of the backing structure (5), wherein the viscous response is in the critical range when the backing structure has a viscosity ($\eta$) for a given thickness (d) of the backing structure such that a ratio of the viscosity over the thickness ($\eta$/d) is between 0.25 MPa·s / m and 5 GPa·s / m.

**Patentansprüche**

1. Stoßfeste Folieneinrichtung (1) mit folgenden Merkmalen:

- eine optische Schicht (2), die von einer Vorderseite (10) der Einrichtung (1) sichtbar ist; und
- eine Elektronik (3) zum Steuern und/oder Bereitstellen einer Schnittstelle zu der optischen Schicht (2); wobei die optische Schicht (2) und die Elektronik (3) in einer flexiblen Folienstruktur (4) enthalten sind, die einen Druckschwellwert ($\sigma_{criti-cal}$) und einen Dehnungsschwellwert ($\varepsilon_{critical}$) aufweist, unterhalb welcher die optische Schicht (2) und die Elektronik (3) nicht beschädigt werden; und
- eine Rückenstruktur (5), die mit der flexiblen Folienstruktur (2) auf ihrer Rückseite, der Vorderseite (10) der Einrichtung gegenüberliegend, mechanisch in Kontakt ist; wobei die Rückenstruktur (5) ein verformbares Material aufweist, das ein viskoses Ansprechverhalten in einem kritischen Bereich hat, wobei der kritische Bereich definiert ist für ein gegebenes Front-Aufprallereignis (9) durch den Druckschwellwert ($\sigma_{critical}$) und den Dehnungsschwellwert ($\varepsilon_{critical}$), wobei der kritische Bereich gewählt ist zwischen einem oberen Schwellenwert, der es der Rückenstruktur (5) erlaubt, sich zu verformen, um fortgesetzt einen Druck auf die flexible Folienstruktur (4) als Folge des Aufstoßes (9), der niedriger ist als der Druckschwellwert ($\sigma_{critical}$), aufrechtzuerhalten; und einem unteren Schwellwert, der die Verformung der Rückenstruktur (5) innerhalb eines maximalen Verformungsbereichs hält, um eine Überdehnung der flexiblem Folienstruktur (4) über den Dehnungsschwellwert ($\varepsilon_{critical}$) hinaus zu vermeiden, wodurch es möglich wird, einen Hauptteil der Aufstoßenergie (9) durch das viskose Ansprechverhalten der Rückenstruktur (5) aufzunehmen, wobei die Rückenstruktur eine Mikro-Zellen-Formschicht aufweist; und wobei das viskose Ansprechverhalten in dem kritischen Bereich liegt, wenn die Rückenstruktur eine Viskosität ($\eta$) für einen gegebene Dicke (d) der Rückenstruktur hat, sodass ein Verhältnis der Viskosität zur Dicke ($\eta$/d) zwischen 0,25 MPa·s/m und 5 GPa·s/m liegt.

2. Einrichtung nach Anspruch 1, wobei die Rückenstruktur eine Viskosität im Bereich von zwischen 250 Pa·s und 5 MPa·s hat.

3. Einrichtung nach einem der vorangehenden Ansprüche, wobei die Rückenstruktur eine Erhöhung ihres Young-Modulus bei einer Verformungstiefe von weniger als 2 mm ausweist.

4. Einrichtung nach einem der vorangehenden Ansprüche, wobei die Einrichtung eine Anzeige ist, wobei die Elektronik dazu eingerichtet ist, einen Anzeigeeffekt in der optischen Schicht anzusteuern, zu steuern und/oder zu erzeugen.

5. Einrichtung nach einem der vorangehenden Ansprüche, wobei die flexible Folienstruktur eine Dicke im Bereich von 50 $\mu$m bis 3000 $\mu$m hat, spezieller in einem Bereich von 50 $\mu$m bis 300 $\mu$m, und wobei die Rückenstruktur eine Dicke im Bereich von 0,5 mm bis 2 cm hat, spezieller im Bereich von 0,5 mm bis 6 mm.

6. Einrichtung nach einem der Ansprüche 1 bis 2, wobei die Einrichtung eine Solarzelleneinrichtung ist, wobei die optische Schicht photovoltaische Zellen aufweist und die Elektronik Verbindungen aufweist, um elektrische Energie zu übertragen, die von den photovoltaischen Zellen erzeugt wurde.

7. Einrichtung nach einem der vorangehenden Ansprüche, wobei die Rückenstruktur flexibler ist als die flexible Folienstruktur.

8. Einrichtung nach einem der vorangehenden Ansprüche, wobei die Rückenstruktur im unverformten Zustand ein Elastizitätsmodul (E) hat, der wenigstens eine Größenordnung kleiner ist als der Elastizitätsmodul der flexiblen Folienstruktur.

9. Einrichtung nach einem der vorangehenden Ansprüche, wobei die flexible Folienstruktur ferner eine Frontschutzschicht (7) und eine Rückenschicht (8) aufweist, wobei die optische Schicht und die Eletroden zwischen der Frontschutzschicht und der Rückenschicht angeordnet sind.

10. Einrichtung nach Anspruch 9, wobei die Frontschutzschicht, die Rückenschicht, die optische Schicht und die Elektronik und die Rückenstruktur jeweils Elastizitätsmodule und Dicken haben derart, dass eine neutrale Ebene der Verformung der kombinierten Schichten im Wesentlichen in der Ebene der optischen Schicht und/oder der Elektronik liegt.

11. Einrichtung nach einem der vorangehenden Ansprüche, mit ferner einem Gehäuse, das eine starre Rückenplatte mit einem Elastizitätsmodul aufweist, der wenigstens eine Größenordnung größer ist als der Elastizitätsmodul der flexiblen Folienstruktur, wobei die Rückenstruktur zwischen der flexiblen Folienstruktur und der starren Rückenplatte angeordnet ist.

12. Einrichtung nach einem der vorangehenden Ansprüche, wobei die flexible Folienstruktur eine Biegestarrheit im Bereich von 0,1 bis 50 mPa·m$^3$ hat.

13. Verfahren zum Vorsehen einer Einrichtung, die widerstandsfähig gegen einen gegebenen Frontaufprall ist, wobei das Verfahren umfasst:

- Bereitstellen einer optischen Schicht (2) und einer Elektronik (3) zum Steuern und/oder Bereitstellen einer Schnittstelle zu der optischen Schicht (2), wobei die optische Schicht (2) und die Elektronik (3) in einer flexiblen Folienstruktur (4) enthalten sind;

- Ermitteln eines Druckschwellwerts ($\sigma_{critical}$) und eines Dehnungsschwellwerts ($\varepsilon_{critical}$) der flexiblen Folienstruktur (4), unterhalb welcher ($\sigma_{critical}$, $\varepsilon_{critical}$) die optische Schicht (2) und die Elektronik (3) nicht beschädigt werden; und

- Auswählen einer Rückenstruktur (5) und Herstellen eines mechanischen Kontakts zwischen der Rückenstruktur (5) und der flexiblen Folienstruktur (4) auf ihrer Rückseite, Frontaufprallseite gegenüberliegend; wobei

- die Rückenstruktur (5) eine verformbare Mikro-Zellen-Formschicht aufweist, die ein viskoses Ansprechverhalten in einem kritischen Bereich aufweist, wobei der kritische Bereich definiert ist für ein gegebenes Front-Aufprallereignis (9) durch den Druckschwellwert ($\sigma_{critical}$) und den Dehnungsschwellwert ($\varepsilon_{critical}$), wobei der kritische Bereich gewählt ist zwischen einem oberen Schwellenwert, der es der Rückenstruktur (5) erlaubt, sich zu verformen, um fortgesetzt einen Druck auf die flexible Folienstruktur (4) als Folge des Aufstoßes (9), der niedriger ist als der Druckschwellwert ($\sigma_{critical}$), aufrechtzuerhalten; und einem unteren Schwellwert, der die Verformung der Rückenstruktur (5) innerhalb eines maximalen Verformungsbereichs hält, um eine Überdehnung der flexiblem Folienstruktur (4) über den Dehnungsschwellwert ($\varepsilon_{critical}$) hinaus zu vermeiden, wodurch es möglich wird, einen Hauptteil der Aufstoßenergie durch das viskose Ansprechverhalten der Rückenstruktur (5) aufzunehmen, wobei das viskose Ansprechverhalten in dem kritischen Bereich liegt, wenn die Rückenstruktur eine Viskosität ($\eta$) für einen gegebene Dicke (d) der Rückenstruktur hat, sodass ein Verhältnis der Viskosität zur Dicke ($\eta$/d) zwischen 0,25 MPa·s/m und 5 GPa·s/m liegt.

## Revendications

1.  Dispositif à film résistant aux chocs (1) comprenant

    - une couche optique (2) qui est visible depuis une face antérieure (10) du dispositif (1) ; et
    - un dispositif électronique (3) pour contrôler la couche optique (2) et/ou lui servir d'interface ; dans lequel
    - la couche optique (2) et le dispositif électronique (3) sont compris dans une structure à film souple (4) qui présente un seuil de pression ($\sigma_{critique}$) et un seuil d'étirage ($\varepsilon_{critique}$) en-dessous desquels les seuils ($\sigma_{critique}$, $\varepsilon_{critique}$), la couche optique (2) et le dispositif électronique (3) ne sont pas endommagés ; et
    - une structure de support (5) qui est en contact mécanique avec la structure à film souple (2) au dos de celle-ci du côté opposé à la face antérieure (10) du dispositif ; dans lequel la structure de support (5) comprend un matériau déformable ayant une réponse visqueuse située dans une plage critique, laquelle plage critique est définie pour un cas de choc frontal (9) donné par le seuil de pression ($\sigma_{critique}$) et le seuil d'étirage ($\varepsilon_{critique}$), la plage critique étant choisie entre un seuil supérieur qui permet à la structure de support (5) de se déformer de manière à maintenir une pression exercée sur la structure à film souple (4) en raison du choc (9) inférieure au seuil de pression ($\sigma_{critique}$) ; et un seuil inférieur qui maintient la déformation de la structure de support (5) dans une plage de déformation maximale de manière à empêcher une extension excessive de la structure à film souple (4) au-delà du seuil d'étirage ($\varepsilon_{critique}$), permettant ainsi à une partie majoritaire d'une énergie du choc (9) d'être dissipée par la réponse visqueuse de la structure de support (5), dans lequel la structure de support comprend une couche de mousse microcellulaire ; et dans lequel la réponse visqueuse se situe dans la plage critique lorsque la structure de support présente une viscosité ($\eta$) pour une épaisseur donnée (d) de la structure de support telle qu'un rapport de la viscosité sur l'épaisseur ($\eta$/d) soit compris entre 0,25 MPa·s / m et 5 Dpa·s / m.

2.  Dispositif selon la revendication 1, dans lequel la structure de support présente une viscosité se situant dans la plage comprise entre 250 Pa·s et 5 MPa·s.

3.  Dispositif selon l'une quelconque des revendications précédentes, dans lequel la structure de support présente une augmentation de son module de Young à une profondeur de compression inférieure à 2 mm.

4.  Dispositif selon l'une quelconque des revendications précédentes, dans lequel le dispositif est un dispositif d'affichage dans lequel le dispositif électronique est conçu pour commander, contrôler et/ou créer un effet d'affichage dans la couche optique.

5.  Dispositif selon l'une quelconque des revendications précédentes, dans lequel la structure à film souple présente une épaisseur se situant dans la plage de 50 $\mu$m à 300 $\mu$m, plus particulièrement dans la plage de 50 $\mu$m à 300 $\mu$m, et la structure de support présente une épaisseur se situant dans la plage de 0,5 mm à 2 cm, plus particulièrement dans la plage de 0,5 mm à 6 mm.

6. Dispositif selon l'une quelconque des revendications 1 à 2, dans lequel le dispositif est un dispositif de cellule solaire dans lequel la couche optique comprend des cellules photovoltaïques et le dispositif électronique comprend des connexions pour transmettre l'énergie électrique générée par les cellules photovoltaïques.

7. Dispositif selon l'une quelconque des revendications précédentes, dans lequel la structure de support est plus souple que la structure à film souple.

8. Dispositif selon l'une quelconque des revendications précédentes, dans lequel la structure de support à l'état non-déformé présente un module d'élasticité (E) qui est au moins une fois plus petit qu'un module d'élasticité de la structure à film souple.

9. Dispositif selon l'une quelconque des revendications précédentes, dans lequel la structure à film souple comprend en outre une couche de protection antérieure (7) et une couche arrière (8), dans lequel la couche optique et le dispositif électronique sont placés entre la couche de protection antérieure et la couche arrière.

10. Dispositif selon la revendication 9, dans lequel la couche de protection antérieure, la couche arrière, la couche optique et le dispositif électronique ainsi que la structure de support ont chacun(e) des épaisseurs et des modules d'élasticité relatifs de sorte qu'un plan neutre d'une déformation des couches combinées se situe sensiblement dans la couche optique et/ou le dispositif électronique.

11. Dispositif selon l'une quelconque des revendications précédentes, comprenant en outre un boîtier ayant une plaque-dossard rigide avec un module d'élasticité qui est au moins une fois plus grand qu'un module d'élasticité de la structure à film souple, dans lequel la structure de support est placée entre la structure à film souple et la plaque-dossard rigide.

12. Dispositif selon l'une quelconque des revendications précédentes, dans lequel la structure à film souple présente une rigidité structurelle se situant dans la plage de 0,1 à 50 mPa·m$^3$.

13. Procédé permettant de fournir un dispositif qui est résistant à un choc frontal donné, le procédé comprenant les étapes suivantes :

- on fournit une couche optique (2) et un dispositif électronique (3) pour contrôler la couche optique (2) et/ou lui servir d'interface ; dans lequel la couche optique (2) et le dispositif électronique (3) sont compris dans une structure à film souple 4) ;
- on détermine un seuil de pression ($\sigma_{critique}$) et un seuil d'étirage ($\varepsilon_{critique}$) de la structure à film souple (4), en-dessous desquels seuils ($\sigma_{critique}$, $\varepsilon_{critique}$), la couche optique (2) et le dispositif électronique (3) ne sont pas endommagés ; et
- on sélectionne une structure de support (5) et on amène la structure de support (5) en contact mécanique avec la structure à film souple (4) sur le dos de celle-ci, du côté opposé au choc antérieur ; dans lequel
- la structure de support (5) comprend une couche de mousse microcellulaire ayant une réponse visqueuse située dans une plage critique, laquelle plage critique est définie pour un cas de choc frontal (9) donné par le seuil de pression ($\sigma_{critique}$) et le seuil d'étirage ($\varepsilon_{critique}$), la plage critique étant choisie entre un seuil supérieur qui permet à la structure de support (5) de se déformer de manière à maintenir une pression exercée sur la structure à film souple (4) en raison du choc (9) inférieure au seuil de pression ($\sigma_{critique}$) ; et un seuil inférieur qui maintient la déformation de la structure de support (5) dans une plage de déformation maximale de manière à empêcher une extension excessive de la structure à film souple (4) au-delà du seuil d'étirage ($\varepsilon_{critique}$), permettant ainsi à une partie majoritaire de l'énergie du choc d'être dissipée par une réponse visqueuse de la structure de support (5), laquelle réponse visqueuse se situe dans la plage critique lorsque la structure de support présente une viscosité ($\eta$) pour une épaisseur donnée (d) de la structure de support telle qu'un rapport de la viscosité sur l'épaisseur ($\eta$/d) soit compris entre 0,25 MPa·s / m et 5 GPa·s / m.

FIG 1

FIG 4

FIG 2

FIG 3

FIG 5

EP 2 551 110 B1

FIG 6

(A)

(B)

(C)

FIG 7

FIG 8

FIG 9

EP 2 551 110 B1

FIG 10

EP 2 551 110 B1

FIG 11

FIG 12

**EP 2 551 110 B1**

**Patent documents cited in the description**

- US 20050077826 A
- US 20100253604 A
- WO 200805420 A
- WO 2008054210 A, Markvoort
- WO 2008054209 A